# EUROPEAN PATENT SPECIFICATION

(11) **EP 2 011 233 B1**
(45) Date of publication and mention of the grant of the patent: **28.09.2011**
(21) Application number: 07732090.1
(22) Date of filing: 21.03.2007
(51) Int. Cl.: H03G 1/00, H03G 3/30

(54) **AUTOMATIC SWITCHED GAIN AMPLIFIER FOR MOBILE RECEPTION**
AUTOMATISCHER SCHALTREGELVERSTÄRKER FÜR MOBILEMPFANG
AMPLIFICATEUR A GAIN COMMUTE AUTOMATIQUE POUR RECEPTION MOBILE

(30) Priority: 03.04.2006 GB 0606721; 12.12.2006 GB 0624704
(43) Date of publication of application: 07.01.2009
(73) Proprietor: University Of Greenwich, London SE10 9LS (GB)
(72) Inventor: CALLAGHAN, Peter, Kent CT2 7TY (GB)
(74) Representative: Brookes Batchellor LLP
(86) International application number: PCT/GB2007/000998
(87) International publication number: WO 2007/113470

(56) References cited:
- US-A- 5 659 582
- US-A1- 2003 155 973
- US-B1- 6 320 913

## Description

### BACKGROUND OF INVENTION

The invention described here relates to the design of an RF amplifier to be used in mobile radio reception. A typical application is for broadcast Radio and TV reception in vehicles, although the invention may also be applied to other types of mobile communication receivers. Current technology uses a medium power amplifier with level control to prevent overload in the presence of strong signals. This gives a compromise in performance for both weak signal (too noisy) and strong signal (Intermodulation products too high). This invention presents a method to use a dynamic threshold that enables a low noise amplifier to be switched out of circuit (bypassed) in the presence of strong signals. This offers best performance in weak and strong signal conditions.

The design of an amplifier for mobile radio reception has always been limited by two extremes. At distances far from a transmitter the received signal is weak and the noise in a system is a limiting factor. This demands a low noise, high gain amplifier. However, close to a transmitter the amplifier will be exposed to large signals. These will create intermodulation products that cause in-band interference. These two requirements are conflicting. For instance low noise amplifier designs are based upon low-power devices with small bias currents but such circuits exhibit excessive intermodulation distortion or even damage in a strong field. Higher power devices invariably have lower gain and poor noise performance, and usually demand a significantly higher power consumption.

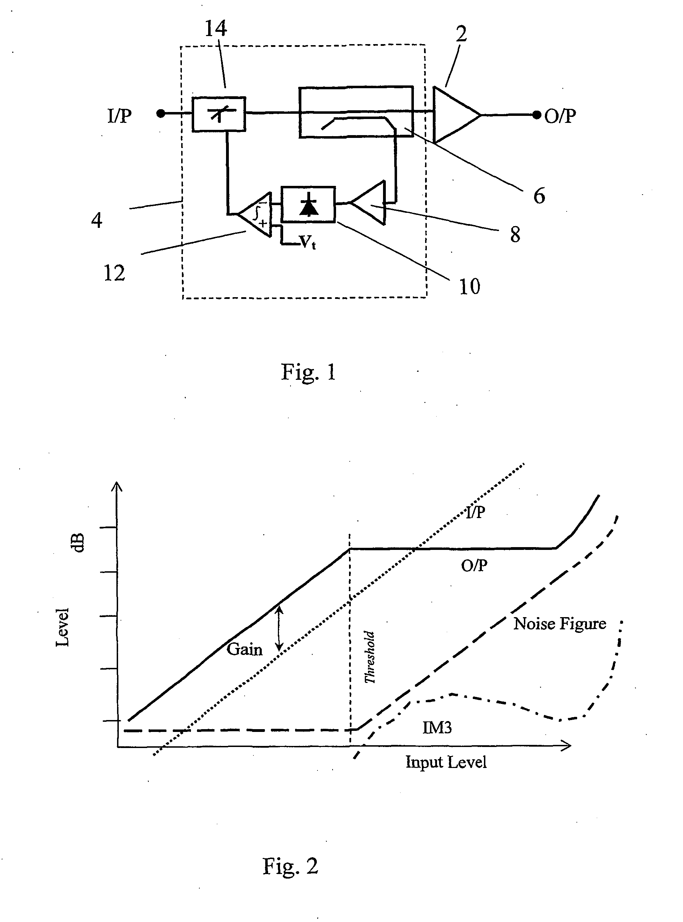

There are techniques to overcome this problem. In the receiver a narrowband tracking filter may be used to reduce the level of unwanted high-power signals, allowing the use of a low power device. However there is increased interest in the use of active antennas whereby the first stage amplifier is sited at the antenna and is therefore separate from the receiver. In this situation the circuit must amplify all 'in-band' signals and therefore an alternative technique is needed. Currently automatic level control is employed using with series attenuation. A typical circuit is illustrated in Fig. 1 with the corresponding characteristic shown in Fig. 2. The amplifier (2) is preceded by an Automatic Gain Control (AGC) circuit (4). Some RF energy is coupled (6) and amplified (8) into a detector (10) that senses the RF signal level. The detected RF level is compared (12) to a threshold voltage (Vt) and if it exceeds this value an error signal is amplified to activate the electronic attenuator (14). The AGC circuit (4) acts as a closed loop such that when the input signal level reaches the threshold level the signal is reduced before amplification, resulting in constant power at the output, as shown in Fig. 2. This prevents the amplifier overloading and therefore allows use of a lower-power design (with better noise figure) for the same application. Of course when the AGC circuit operates the attenuation causes a loss of sensitivity, as shown by the curve for noise figure in Fig. 2. Also the AGC circuit itself generates intermodulation products and these additional Intermodulation Products can be higher than those generated in the amplifier now operating at a lower level. (Curve IM3 denoting 3^{rd} Order Intermodulation Products).

Such circuits have been designed and used successfully for mobile FM and TV reception by a many automotive antenna companies and an integrated circuit based on this concept is available from TEMIC. However, the solution is not ideal. These circuits usually still use a medium bias, low gain amplifier and these do not provide the best sensitivity. Also the AGC circuit can still suffer from significant levels of intermodulation products. The advent of digital systems will demand improved sensitivity while multi-carrier systems, such as DAB Radio, will demand an even higher level of protection from distortion. Variations on this basic AGC circuit have been proposed. US5339454 uses additional level information from sideband filters to optimise the AGC control but requires integration with the receiver. US4066977 introduces a 'gain hysteresis' circuit such that the AGC takes out only large variations only (not small variations in signal level within the hysteresis band) but has no benefit to broadcast mobile reception. There are more sophisticated AGC circuits such as US6420934 whereby the AGC action is varied according to different signal conditions, to provide fast or slow AGC, but still suffers from the need for a compromise on the basic amplifier performance and intermodulation distortion.

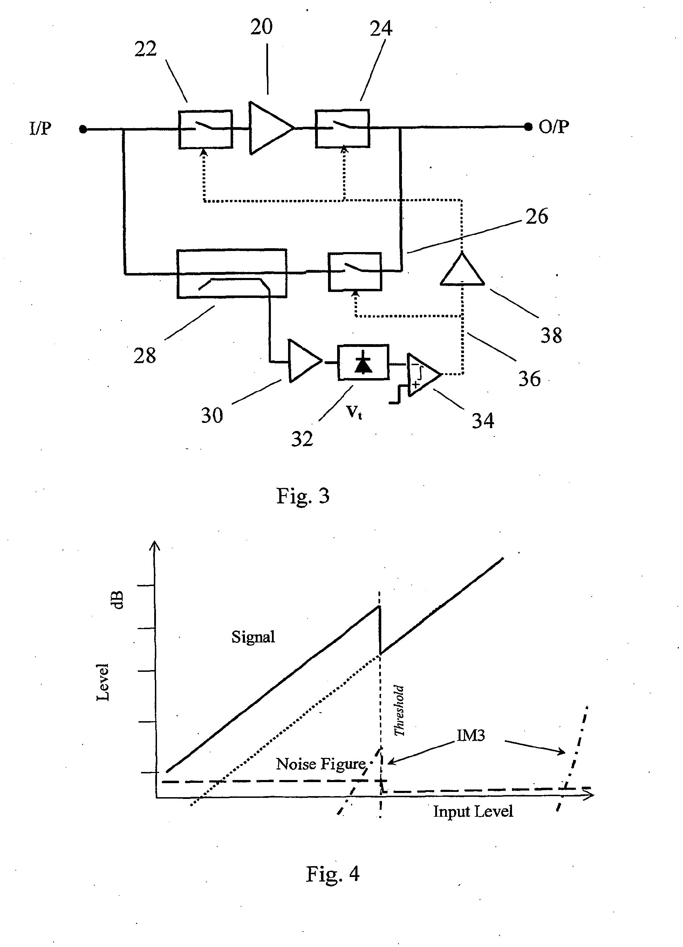

An alternative approach is to use a switched gain circuit. Instead of using the continuously varying series attenuator, the low noise amplifier is switched out of circuit when the signals exceed a threshold level and the wanted signal is routed via a higher power amplifier or even just a through line (as a bypass). Such an arrangement is shown in Fig. 3. When the detected level exceeds the reference level, Vₜ, the comparator switches in the bypass circuit, 26, on, while the inverter, 38, switches the amplifier, 20, out of circuit by two RF switches, 22 at the input and 24 at the output. Note the bypass circuit could incorporate another amplifier (a 'through' being essentially a zero gain amplifier), hence the name automatic switched gain amplifier. The overall circuit has the desired performance shown in Fig. 4. Noise is at a minimum, intermodulation products are at a minimum while the signal is amplified at low level, and has minimal attenuation at high levels. Switched gain amplifiers have been proposed for similar applications. In EP1309083 a switched gain amplifier circuit is optimised for low / high field conditions for mobile phone applications. Similarly, a 'bypass' circuit is described in US6060949 for a transmitter circuit. However these designs assume external control of the switching (but in this invention automatic control is used.

The circuit of Fig. 3 has a basic instability problem. It assumes the detected signal level remains constant before and after switching. In practical systems this level changes due to a variation in the RF load impedances. In particular for active antennas the 'load' will be a receiver having a tracking bandpass filter loads the amplifier. At low levels the source (say an antenna) sees the input impedance of the amplifier, which is usually a good match across the band. When the bypass circuit is switched on the source sees a bandpass response and only inband signals will be received. As in practice there are a number of other high level signals (interferers) the amplitude of these at the detector will be dramatically altered. As the RF detector senses the total RF energy then the detected level will vary - often by a significant amount. This could mean the comparator senses a fall in signal level and switches the amplifier back in to circuit! Hence this causes instabilities in the feedback loop that cannot be tolerated. One solution to this problem that has been applied is to introduce attenuation in the bypass circuit such that the mismatch is reduced. However this negates the benefit of a bypass circuit (introduction of excessive loss) and it would be preferable to use the series AGC circuit of Fig. 1.

### SUMMARY OF INVENTION

The invention described here is to adapt the automatic switched bypass circuit such that it can tolerate changes in the detected RF level caused by switching, achieving the ideal characteristic of Fig. 4. This change in level is indeterminate as both the number of signals present and their respective levels is unknown and also the load impedance is dynamic (i.e. a tracking filter). The Circuit disclosed here alters the threshold level used by the comparator before and after switching to prevent instabilities. Furthermore it is proposed to introduce a circuit that measures the change in the detected signal on switching and use this to change the threshold level accordingly for optimum performance.

### BRIEF DESCRIPTION OF FIGURES

Fig. 1 is a circuit diagram of a conventional amplifier with series level control.
Fig. 2 illustrates the electrical performance of the circuit in Fig. 1 showing how the gain, noise and intermodulation performance vary with input signal level.
Fig.3 is a circuit diagram for an amplifier using a switched 'bypass' arrangement.
Fig. 4 illustrates the ideal electrical performance of the circuit in Fig. 5 showing how the gain, noise and intermodulation performance vary with input signal level.
Fig. 5 is an automatic switched gain amplifier according to this invention that uses a dynamic threshold to compensate for the mismatch loss effect.
Fig. 6 illustrates how the reference level is varied in line with changes in the detected voltage.
Fig. 7 illustrates a typical analogue circuit that can provide a dynamic threshold.
Fig. 8 illustrates some voltage variations with time for the circuit in Fig. 7 to illustrate how the dynamic threshold circuit operates
Fig. 9 is an automatic switched gain amplifier according to this invention using a microprocessor to provide the dynamic threshold circuit.
Fig. 10 is a more complex circuit using more than one amplifier.
Fig. 11 is a flow diagram for the two amplifier circuit of Fig. 10
Fig. 12 illustrates switching signals around the LNA to enhance the dynamic range of the detector whilst minimising the circuitry

### MAIN BODY OF INVENTION

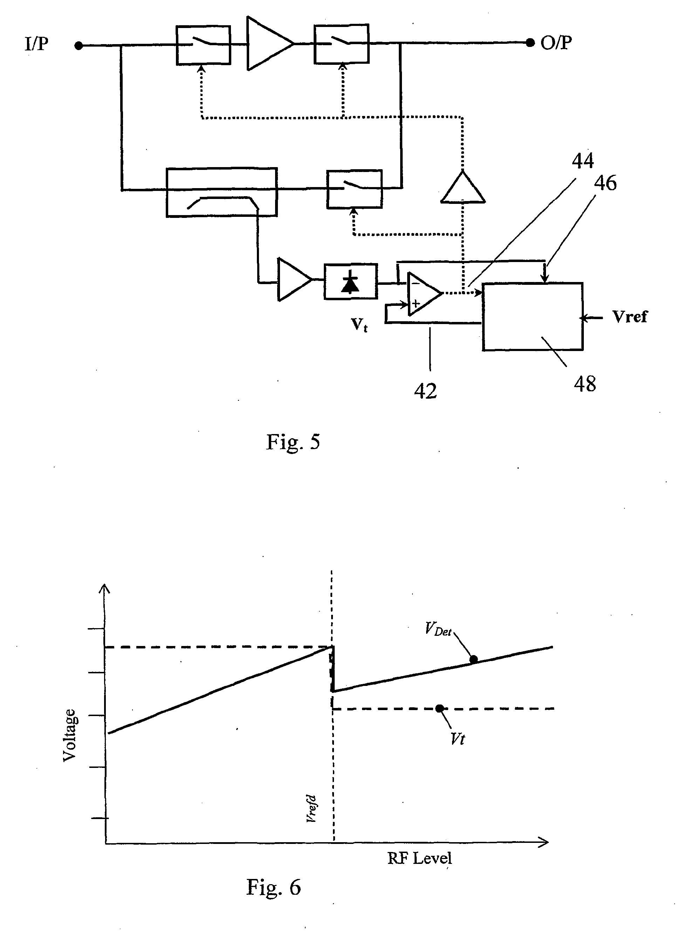

The invention described here is to alter the threshold voltage used by the comparator dynamically to compensate for the change in the detected voltage caused by switching. A typical circuit for this is shown in Fig. 5. In the circuit of Fig. 3 the threshold value, Vt, was fixed. In this invention there is a nominal reference level, V_{ref}, that is used for the initial threshold point for switch-on (i.e. the amplifier impedance and the maximum desired input RF level is known). However, rather than use a fixed value for Vₜ, the invention is to change this using a control circuit (48). When the detected level exceeds the threshold the comparator switches as before. The control signal (44) triggers the control circuit into reducing the threshold voltage. This variation of detected voltage with corresponding change in the comparator reference threshold voltage is illustrated in Fig. 6.

It is expected that the detected voltage will fall on switching as the broadband match of the load is usually poorer (i.e. due to tracking filter) than with the amplifier in circuit, and therefore the amplitude of 'out-of-band' signals will be reduced. In the basic form of this invention the threshold level reduced by a fixed amount. To prevent false switching this reduction has to be at least as great as the largest change in detected voltage that could be expected. For instance it may be expected there are up to ten broadcast signals of significant amplitude and on switching the load becomes high impedance for nine of these (the in-band signal seeing a load). The detected level will therefore increase at least 6 dB (average voltage doubled) and therefore the threshold should be reduced by more than 6 dB - say 8dB. Note that this means the amplifier will likely be switched out of circuit too long - that is as the input levels fall the circuit will 'hold-off' until the 8dB drop is reached. The actual change needed will be dependant on the application - the numbers here are for illustration only. To ensure the circuit remains stable under all conditions the fixed change in threshold needs to be larger than the maximum expected change in detected voltage.

An improved version of the invention is to make the magnitude of this change of threshold voltage dynamic. Here the 'switch-on' signal (44) triggers the control circuit into measuring the RF detected level (46) immediately after the circuit switches. The change in detected voltage due to the change in mismatch affecting the composite signal present at the time of switching is now known, as it was equal to the threshold level before switching The threshold level (42) can then be adjusted by the same amount - that is the threshold level is made equal to the new detected signal level after switching. The bypass circuit will now remain on until the RF signals fall below the threshold again. At this point the reverse happens - the control circuit senses the switch-off signal and returns Vₜ to the nominal value. In practice making the threshold exactly equal to the detected level after switching will cause false switching (i.e. signal not less than new threshold) so the new threshold should be made slightly smaller than the detector level (say 5% less). Importantly as the change in threshold is determined dynamically optimum performance of the circuit is achieved. For instance if there are only two strong signals rather than ten the change in detected level may only be 2-3 dB, and therefore the threshold is not reduced as much, allowing the amplifier to be switched back into circuit more readily. More importantly varying the change in threshold ensures the loop is stable.

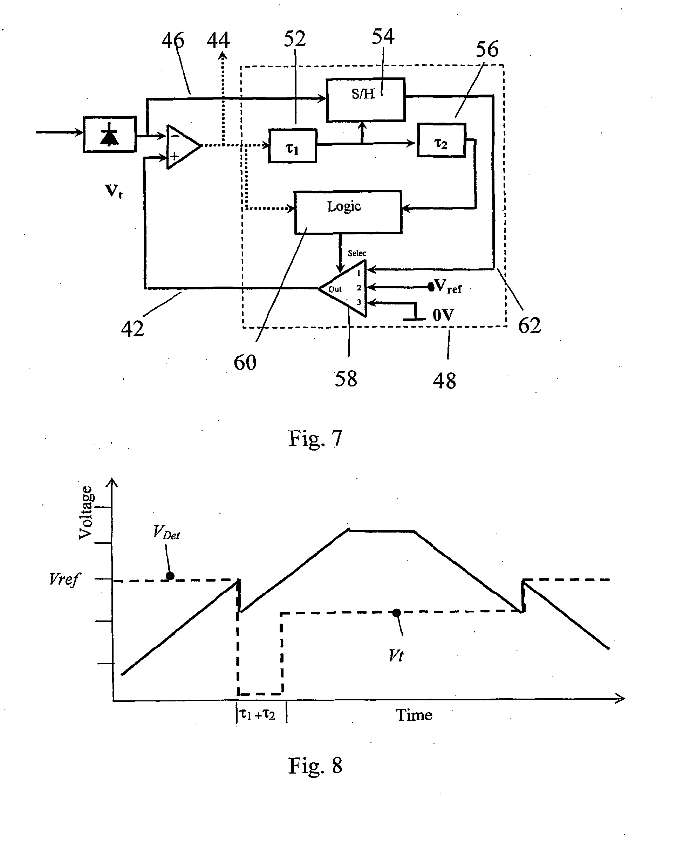

The control circuit (48) may be realised using various techniques. In a first embodiment it can be constructed using an 'analogue' circuit. One example is illustrated in Fig. 7. The threshold value (42) is switched between three values via a multiplexer (58) controlled by a logic circuit (60). Initially for a weak signal the threshold level is set to a reference level V_{ref}. As the signal increases the detected signal (46) exceeds the threshold (42) and the output of the comparator (44) switches state, switching the RF signal to the bypass circuit. The change in the detected level (46) is measured using a Sample and Hold circuit (54). However the circuit has to allow for 'settling' of the detected signal as the detector will normally include an integrating or averaging circuit. To achieve this the threshold is switched to zero via the multiplexer (58) when the comparator switches state. This ensures the switch stays 'on'. The activation of the Sample and Hold circuit (54) is delayed using a monostable (52) to ensure the detected level has settled. After sampling the detected level (i.e. the change), this value (62) is switched by the multiplexer to provide the new threshold level. Again a small delay may be introduced for stability (56). As the received signal level falls the comparator will switch state again. This time the logic selects reference level, Vₜ, directly - there is no need to measure the detected voltage. Fig. 8 illustrates the ideal characteristic of threshold and detected voltage against time as the received signal increases and decreases. Note the 'hold-off' time (τ₁+τ₂) not only ensures stable operation of the circuit but may be used to reduce excessive switching of the circuit.

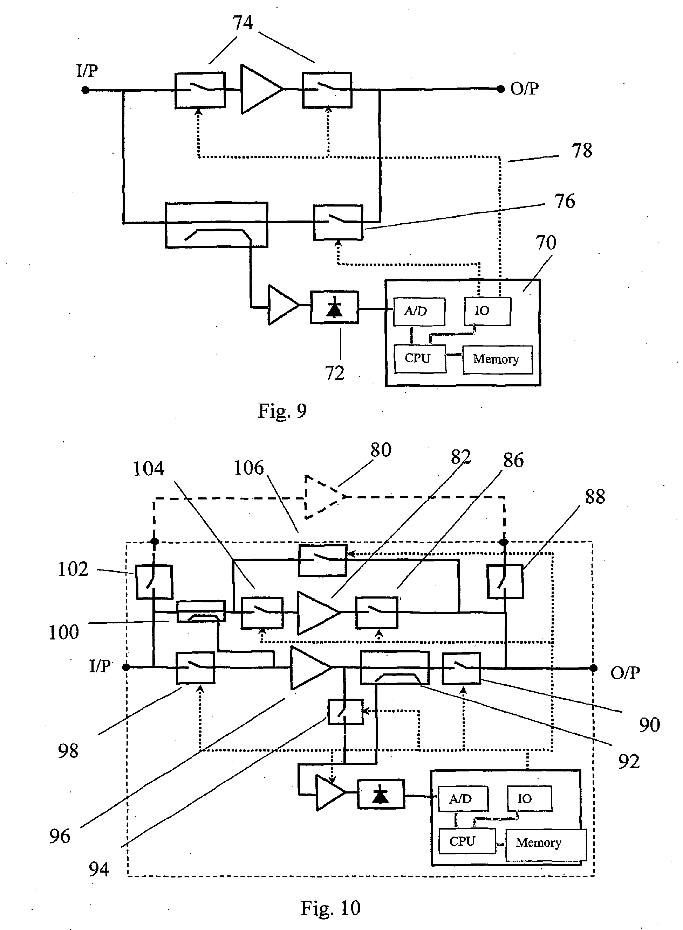

A second embodiment is to use a digital control circuit. The analogue signals can be converted to digitised values and a logic circuit with appropriate timings can be arranged to provide the function required by the sub-circuit 48 of Fig. 5. However a further, preferred embodiment would be to incorporate the comparator function in the digital circuit, as indicated by the circuit of Fig. 9. This makes the circuit easier and cheaper to realise. Indeed the control circuit, 70, is likely to be realised as a single-chip micro controller. Only the detected signal is converted to a digital form via an analogue to digital converter. Here care is needed to ensure the digitised RF level has sufficient resolution (digital bits) to provide significant accuracy in the measurable change in RF level due to the change in RF impedances. The control is now accomplished by 'software'. The programme is relatively simple - it monitors the detected level and when it exceeds the threshold the bypass circuit is switched in. The programme can then measure the change in RF detected level and determine the new threshold level to use before the bypass circuit is switched out. The switch is completely under control and therefore there are no possibilities of control loop instabilities. The control of the switch is achieved by use of the input/output lines from the microprocessor. Not only does this approach offer a simpler and cheaper alternative to the analogue approach but allows additional functions to be incorporated. For instance the programme may include compensation factors for temperature (amplifier and detector characteristic) to optimise performance. Additionally the software can monitor the switching activity and instigate a hold-off/hold-on decision (i.e. where the level is varying rapidly around the threshold level).

Where a digital control circuit is proposed clock noise may be introduced to the RF signal, causing a loss in noise figure. While this can be minimised by careful design it can be reduced significantly by using an asynchronous clock. Here the clock period varies with time such that it has a broad frequency spectrum - lowering the amount of energy and therefore noise, in any particular frequency band.

It is expected that the switched gain RF amplifier circuit can be realised in a fully integrated form. For example, in the field of active antennas, current designs use PIN devices to provide the low-distortion attenuators while the RF gain stage often relies upon 'specialised' medium power low noise transistors operating a common base mode for low-distortion, often employing a feedback transformer. This makes such circuits difficult to integrate. (The TEMIC device relies upon external components) This invention allows use of simple RF switches and a low-power low-noise device for the RF gain block. These can be fabricated using CMOS technology, along with the rest of the sensing / control circuit. The preferred embodiment of this invention is therefore realisation as an integrated circuit.

Using a micro controller, as in Fig. 9 allows easy addition of further features. (These may be also realised using analogue circuitry, but the circuit complexity and cost is much greater). For instance one further embodiment would be to not only switch the 'bypass' circuit around the preferred low-power, low-noise amplifier but to switch in one or more medium-power amplifiers at 'intermediate' power levels. This would give a 'stepped' characteristic that may be tailored for optimum performance - providing increased sensitivity in the presence of medium strength interfering signals. An alternative embodiment of this is that instead of using a second medium power amplifier, the micro controller switches the bias point of the preferred LNA amplifier to provide the intermediate amplifier. Fig. 10 presents a possible two-amplifier solution for realisation as an IC.

In Fig. 10 the main Low Noise Amplifier 96 is switched into circuit by 98 and 90, with a second Medium Power Amplifier, 82, switched via 104 and 86 with a bypass (through-line) provided by 106. To increase the detector sensitivity the signal is coupled via 92 from the output of the LNA to the detector circuit. When the LNA is switched out of circuit it is then used as the first stage of the detector buffer amplifier by coupling signal direct from the input port, 100, with the output of the LNA switched directly to the detector circuit using 94.

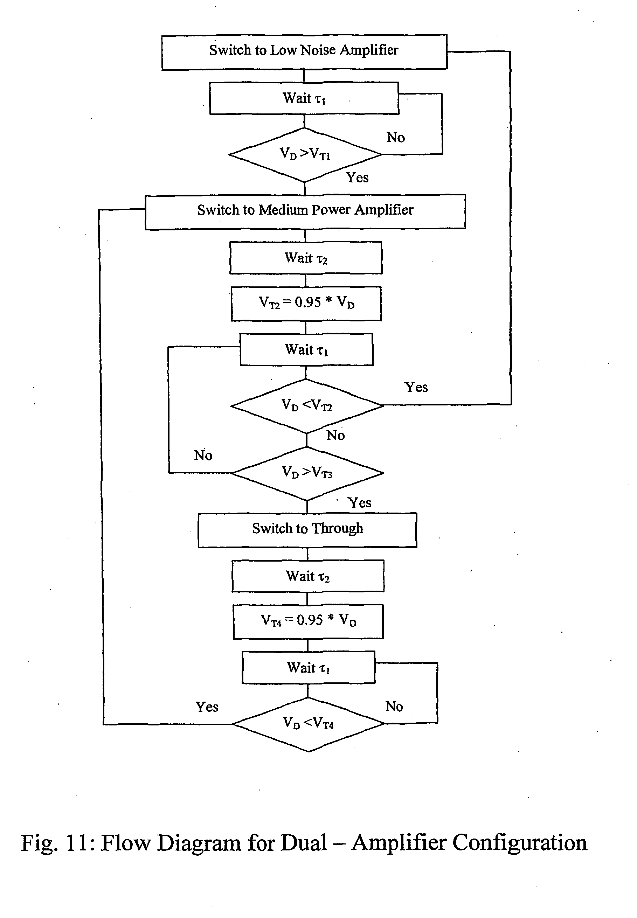

The switched amplifier circuit of Fig. 10 is controlled by an on-chip micro-controller and Fig. 11 presents a typical flow diagram for operation of the overall circuit. Initially the LNA is switched into circuit. The circuit waits for a hold-off period, τ₁, (say 1 second) before testing if the signal has exceeded the nominal threshold, V_{T1}, for the LNA. When V_{T1} is exceeded the Medium Power Amplifier is switched into circuit. The threshold, V_{T2}, is now set to be slightly less than the detector level measured after a short period τ₂ to allow settling time for the circuit (say 10 ms). Again after a hold-off period of τ₁, the detected signal is now checked. If it has fallen below V_{T2} the LNA is switched back into circuit. If it exceeds a new threshold V_{T3} then the through line is switched into circuit. V_{T3} is determined by adding an offset to V_{T2} equating to the increase of the nominal threshold point of the MPA to the LNA. Finally a new threshold of V_{T4} is determined from the measured detected signal level, again after allowing for settling from which the through line is held in until the signal falls again. As the signal falls the MPA is switched in and then the LNA. Using the MPA as an intermediate stage reduces the change in signal level when switching (the LNA gain may be 15-20 dB while the MPA may be only 5-10 dB) which can reduce any switching noise as well as increasing the range of sensitivity. As two switching points are needed the dynamic range of the detector needs to be wider. It may be the buffer amplifier gain needs to be adjusted; hence Fig. 10 shows the microcontroller IO lines connecting to the buffer. For instance when the MPA is switched into circuit and the buffer amplifier gain is reduced (perhaps by switching out a gain stage) to allow accurate measurement of signal levels at higher levels. An alternative solution is to use a logarithmic amplifier to amplify the detector output. However, switching the buffer gain may be easier to implement and may offer additional benefits such as reducing Intermodulation Products from the buffer amplifier in very high signal conditions that could leak to the output.

For an IC it may be the performance of the LNA may be limited and therefore an option to provide an alternative LNA off-chip can be accommodated by additional switches 102 and 88. In this instance the nominal threshold level V_{T1} may also need to be changed to suit the external amplifier. A simple solution would be to provide a programming pin to the IC whereby a non-zero voltage will provide information to the controller to set V_{T1}, while a zero control voltage selects the on-chip LNA.

Use of a micro-controller would allow ease of implementation of dynamically changing the hold-off times to reduce excessive switching. The controller can monitor the amount of switching and increase the hold-off times, τ₁, and/or change the Threshold points to reduce switching. Increasing hold-off time changes the rate of switching whilst changing the threshold points can be used to bias the switching to one state (i.e. hold in the through line state when in a marginal area).

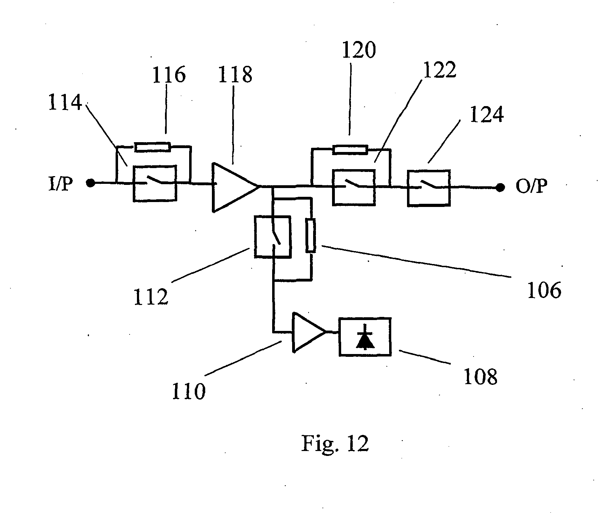

Fig. 12 presents a circuit arrangement that not only allows use of the LNA to increase the dynamic range of the detector but to re-use the LNA as the MPA. A resistor 118 is placed in series with the output of the LNA. This can be bypassed by the RF switch 120 such that the LNA operates in it's normal low noise condition. However when switch 120 is open circuit the series resistor increases the load resistance. This reduces the gain of the LNA but can increase the gain saturation point, that is , it will improve the intermodulation performance. Typically a 15 dB LNA can have it's gain reduced by 7 dB with a >10 dB improvement in intermodulation, hence providing the MPA. To couple the signal to the buffer amplifier (nominally 50Ω impedance) a resistor is used (∼1 kΩ). When the amplifier is switched out of circuit (both LNA and MPA) by 114 and 124 then this resistor can be bypassed using switch 112. Resistor 116 (again ∼1 kΩ) provides a coupling path to the input port to sense the signal level- that is switch 106 is closed when switch 114/124 are opened. This circuit arrangement not also improves detector sensitivity but reduces component count and current consumption.

The automatic switched gain amplifier circuit allows use of the lowest noise amplifier; yet will perform well in the presence of strong signals. In the field of mobile radio reception such circuits will not only provide an improvement in current FM and TV reception but offer a significant advantage to the new digital systems (DAB, DVB-T, SDARS). For digital systems noise is the limiting factor and a high gain low-noise amplifier is essential for an active antenna. Another advantage of this approach is a reduction in power consumption. Current FM ALC designs draw in excess of 30 mA from a 12V supply (∼0.5W) to meet specification. An Automatic Switched Gain Amplifier uses low current circuits and may draw less than 10 mA - potentially only a few mA in an Integrated Circuit form (20 mW). Where a number of antennas are used on a vehicle (i.e. FM diversity, AM, DAB) this could mean saving in excess of 1W of power. This is a key benefit where the automotive manufacturer is looking to reduce energy losses.

The following summary, which provides an abstract, is included here in the main body of the text: The invention disclosed here relates to the design of an automatic switched gain amplifier to be used in mobile radio reception, particularly for broadcast radio and TV reception in vehicles. Current technology uses a medium power amplifier with automatic level control to prevent overload in the presence of strong signals. This gives a compromise in performance for both weak signal (noise figure too high) and strong signal (excessive distortion). This invention describes application of a dynamic threshold that enables use a switched gain amplifier, avoiding control loop instabilities usually encountered in these systems. This allows for optimum signal reception in both weak and strong signal conditions.

## Claims

1. An amplifier circuit for radio frequencies that switches gain automatically depending on the signal level, comprising:
At least one amplifier
A 'through' line (i.e. a bypass circuit)
A switching circuit to route the signal either through the amplifier or via the 'through' line **characterized by**
Means to measure the signal level at the input to the circuit providing a detected signal level, the detected signal level being measured before and after switching,
a control circuit that switches the switching circuit depending upon the detected signal level relative to a threshold level and
means (48) to alter the threshold by an amount relative to the change in the detected signal from before switching to after switching

2. The circuit of claim 1 comprising more than one amplifier in parallel the additional amplifiers having different gain / noise characteristics whereby the circuit switches between each amplifier and the bypass with the threshold adjusted dynamically

3. The circuit of claims 1or 2 whereby one gain characteristic of the amplifier is that of a low noise amplifier.

4. The circuit of claims 1 to 3 whereby the measurement circuit comprises a sample and hold circuit with timing circuits and the control circuit is comprised of a comparator.

5. The circuit of any of the preceding claims comprising means to set zero threshold level and means (52) to force hold-off hold-off during averaging time of the detection after switching.

6. The circuit of any of the preceding claims whereby a delay circuit (56) is included in the control circuit to prevent excessive switching.

7. The circuit of claims 1 to 3 whereby the measuring and control circuit is provided by a digital micro-controller , and the detected signal is converted to a digital form using an A/D converter

8. The circuit of claim 7 whereby the microcontroller is used to dynamically adjust bold-off times and threshold levels to avoid excessive switching rates.

9. The circuit of claim 8 comprising means (88,102) to provide an additional, amplifier externally (off-chip).

10. The circuit of any of the preceding claims whereby the circuit forms an RF amplifier used in mobile reception of radio signals

11. The circuit of claim 10 whereby the amplifier is part of an antenna matching unit.

## Patentansprüche

1. Verstärkungsschaltung für Funkfrequenzen, die den Verstärkungsfaktor in Abhängigkeit von dem Signalpegel automatisch schaltet, mit:
mindestens einem Verstärker,
einer "Durchgangs"-Leitung (z.B. Bypass-Schaltung),
einer Umschalt-Schaltung zum Leiten des Signals entweder durch den Verstärker oder durch die "Durchgangs"-Leitung,
**gekennzeichnet durch**
Vorrichtungen zum Messen des Signalpegels an dem Eingang zu der Schaltung, um einen detektierten Signalpegel zu erhalten, wobei der detektierte Signalpegel vor und nach dem Schalten gemessen wird,
eine Steuerschaltung, welche die Umschalt-Schaltung in Abhängigkeit von dem detektierten Signalpegel relativ zu einem Schwellwertpegel schaltet, und
Vorrichtungen (48) zum Ändern des Schwellwerts um einen Betrag relativ zu der vom Zustand vor dem Schalten bis zum Zustand nach dem Schalten erfolgten Veränderung des detektierten Signals.

2. Schaltung nach Anspruch 1, mit mehr als einem einzigen Verstärker in paralleler Anordnung, wobei die zusätzlichen Verstärker verschiedene Verstärkungsfaktor/Rausch-Charakteristiken haben, wobei die Schaltung zwischen jedem Verstärker und dem Bypass umschaltet und dabei der Schwellwert dynamisch angepasst wird.

3. Schaltung nach Anspruch 1 oder 2, bei der ein Verstärkungsfaktor des Verstärkers derjenige eines rauscharmen Verstärkers ist.

4. Schaltung nach einem der Ansprüche 1 bis 3, bei der die Mess-Schaltung eine Abtast- und Halteschaltung mit Zeitsteuerungsschaltungen aufweist und die Steuerschaltung einen Komparator aufweist.

5. Schaltung nach einem der vorhergehenden Ansprüche, mit Vorrichtungen zum Setzen eines Null-Schwellwert-Pegels und Vorrichtungen (52) zum Erzwingen einer Verzögerung während der Mittelwertbildung der Zeit des Detektors nach dem Schalten.

6. Schaltung nach einem der vorhergehenden Ansprüche, bei der in der Steuerschaltung eine Verzögerungsschaltung (56) enthalten ist, um übermäßiges Schalten zu verhindern.

7. Schaltung nach einem der Ansprüche 1 bis 3, bei der die Mess- und Steuerschaltung in Form einer digitalen Mikrosteuervorrichtung vorgesehen ist und das detektierte Signal mittels eines A/D-Konverters in eine digitale Form umgesetzt wird.

8. Schaltung nach Anspruch 7, bei der die Mikrosteuervorrichtung zum dynamischen Anpassen von Verzögerungszeiten und Schwellwertpegeln verwendet wird, um übermäßige Schaltraten zu verhindern.

9. Schaltung nach Anspruch 8, mit Vorrichtungen (88,102) zur Bildung eines zusätzlichen Verstärkers im externen Bereich (off-chip).

10. Schaltung nach einem der vorhergehenden Ansprüche, wobei die Schaltung einen RF-Verstärker bildet, der zum mobilen Empfang von Funksignalen verwendet wird.

11. Schaltung nach Anspruch 10, bei der der Verstärker ein Teil einer Antennenanpassungseinheit ist.

## Revendications

1. Circuit amplificateur destiné à des fréquences radio, lequel commute automatiquement le gain en fonction du niveau de signal, comportant :
au moins un amplificateur ;
une ligne "de transfert" (c'est-à-dire un circuit de dérivation) ;
un circuit de commutation pour acheminer le signal, soit à travers l'amplificateur, soit via la ligne "de transfert", **caractérisé par**
des moyens pour mesurer le niveau du signal au niveau de l'entrée du circuit fournissant un niveau de signal détecté, le niveau de signal détecté étant mesuré avant et après la commutation,
un circuit de commande qui commute le circuit de commutation en fonction du niveau de signal détecté par rapport à un niveau de seuil et
des moyens (48) pour modifier la valeur de seuil d'une quantité relative à la variation du signal détecté depuis avant la commutation jusqu'à après la commutation.

2. Circuit selon la revendication 1 comprenant plus d'un amplificateur en parallèle, les amplificateurs supplémentaires présentant différentes caractéristiques de gain de bruit, de sorte que le circuit commute entre chaque amplificateur et le circuit de dérivation avec la valeur de seuil ajustée de façon dynamique.

3. Circuit selon les revendications 1 ou 2 dans lequel une caractéristique de gain de l'amplificateur est celle d'un amplificateur de faible bruit.

4. Circuit selon les revendications 1 à 3 dans lequel le circuit de mesure comporte un circuit d'échantillonnage et de maintien dotés de circuits de synchronisation et le circuit de commande est composé d'un comparateur.

5. Circuit selon l'une quelconque des revendications précédentes comportant des moyens permettant d'établir un niveau de seuil nul et des moyens (52) pour imposer un blocage pendant le temps de mesure des valeurs moyennes du détecteur après la commutation.

6. Circuit selon l'une quelconque des revendications précédentes dans lequel une ligne à retard (56) est incorporée dans le circuit de commande pour empêcher une commutation à l'excès.

7. Circuit selon les revendications 1 à 3 dans lequel le circuit de mesure et de commande est doté d'un microcontrôleur numérique, et dans lequel le signal détecté est converti sous une forme numérique en utilisant un convertisseur Analogique - Numérique.

8. Circuit selon la revendication 7, dans lequel le microcontrôleur est utilisé pour ajuster de façon dynamique des temps de blocage et des niveaux de seuil afin d'éviter des vitesses de commutation excessives.

9. Circuit selon la revendication 8 comportant des moyens (88, 102) pour fournir un amplificateur supplémentaire en externe (hors circuit).

10. Circuit selon l'une quelconque des revendications précédentes dans lequel le circuit forme un amplificateur RF utilisé pour la réception mobile de signaux radio.

11. Circuit selon la revendication 10 dans lequel l'amplificateur fait partie d'une unité d'adaptation d'antenne.
